Europäisches Patentamt

European Patent Office

Office européen des brevets

(11) Publication number: **0 243 075 B1**

# EUROPEAN PATENT SPECIFICATION

(45) Date of publication of patent specification: **23.10.91**

(51) Int. Cl.⁵: **H03M 5/14**, G11B 20/14, //G11B5/012

(21) Application number: **87303274.2**

(22) Date of filing: **14.04.87**

(54) Frequency multiplying circuit.

(30) Priority: **18.04.86 JP 90357/86**

(43) Date of publication of application:
**28.10.87 Bulletin 87/44**

(45) Publication of the grant of the patent:
**23.10.91 Bulletin 91/43**

(84) Designated Contracting States:
**DE FR GB**

(56) References cited:
**GB-A- 2 109 203**
**US-A- 3 893 042**
**US-A- 4 344 039**

**PATENT ABSTRACTS OF JAPAN, vol. 8, no. 8
(E-221)[1445], 13th January 1984; & JP-A-58
172 045**

**PATENT ABSTRACTS OF JAPAN, vol. 9, no.
154 (E-325)[1877], 28th June 1985; & JP-A-60
32 431**

**PATENT ABSTRACTS OF JAPAN, vol. 3, no.
31 (E-098), 16th March 1979, page 73 E98; &
JP-A-54 10 652**

**ELECTRONICS LETTERS, vol. 11, no. 22, 30th
October 1975, pages 541-542; J.D.H. ALEXAN-
DER: "Clock recovery from random binary
signals"**

(73) Proprietor: **FUJITSU LIMITED
1015, Kamikodanaka Nakahara-ku
Kawasaki-shi Kanagawa 211(JP)**

(72) Inventor: **Satoh, Nakatoshi
1-4 Todoroki 6-chome
Setagaya-ku, Tokyo 158(JP)**

(74) Representative: **Rackham, Stephen Neil et al
GILL JENNINGS & EVERY 53-64 Chancery
Lane
London WC2A 1HN(GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

The present invention relates to a frequency multiplying circuit. The frequency multiplying circuit according to the present invention can be applied, for example, in read signal generation in a disc controller used, for example, for a floppy-disc controller of a personal computer.

In general, digital data, with the FM type modulation and the modified FM type (MFM type) and stored in a disc memory as an external memory of a computer is reproduced by a reproducing device having a phase locked loop circuit, a frequency multiplying circuit, and a data reading circuit.

The phase locked loop circuit extracts a clock signal from the reproduced signal. The frequency of the extracted clock signal is multiplied by two by the frequency multiplying circuit. The frequency multiplied signal is supplied as a data reading clock signal to the data reading circuit. The data reading circuit reads the clock bits and the data bits from the regenerated signal by using the data reading clock signal.

Usually, in the prior art frequency multiplier circuit used for the disc controller, the oscillation frequency in the phase locked loop circuit is subject to considerable changes in a lock-in process with regard to a regenerative signal, so that the frequency of the clock signal is subject to considerable changes. As the frequency of the clock signal increases, the lengths of LOW level potential periods become quite short, causing the frequency of the output signal to be high. This high frequency of the output signal causes an abnormal operation of the data reading circuit, and prevents a data reading circuit from performing a normal operation.

Accordingly, problems have occurred in that the clock bits and data bits cannot be read, and that an error signal indicating an error in the data reading cannot be generated.

According to this invention a frequency multiplying circuit comprises:

a reference input frequency;

a first time counting means responsive to input pulse signals for producing a first detection signal when said input pulse signals maintain a HIGH level for a time greater than that required for a predetermined number of periods of the reference input;

a second time counting means responsive to the input pulse signals for producing a second detection signal when said input pulse signals maintain a LOW level for a time greater than that required for a predetermined number of periods of the reference input;

a pulse generation determining means responsive to said produced first and second detection signals for realizing a SET state by said produced first detection signal and realizing a RESET state by said produced second detection signal to generate gate signals;

a first pulse generating means responsive to one of said generated gate signals for detecting rising edges of said input pulse signals to generate first pulses which are substantially synchronous with said rising edges;

a second pulse generating means responsive to the other of said generated gate signals for detecting falling edges of said input pulse signals to generate second pulses which are substantially synchronous with said falling edges;

said first and second pulses being delivered as frequency multiplied signals of said input pulse signals;

whereby the frequency multiplication of said input pulse signals only occurs when the period of said input pulse signals exceeds the time required for a predetermined number of periods of the reference input.

A particular example of a frequency multiplier circuit in accordance with this invention will now be described and contrasted with the prior art with reference to the accompanying drawings; in which:-

Figure 1 is a circuit diagram of a prior art disc controller including a frequency multiplier circuit;

Figure 2 shows waveforms of the signals in the prior art disc controller;

Figure 3 is a circuit diagram of a frequency multiplying circuit according to a preferred embodiment of the present invention;

Figures 4 to 7 show waveforms of the signals in the frequency multiplying circuit shown in Figure 3 under four conditions; and,

Figure 8 shows a data latch circuit to which the output signal of the frequency multiplying circuit of Figure 3 is sent.

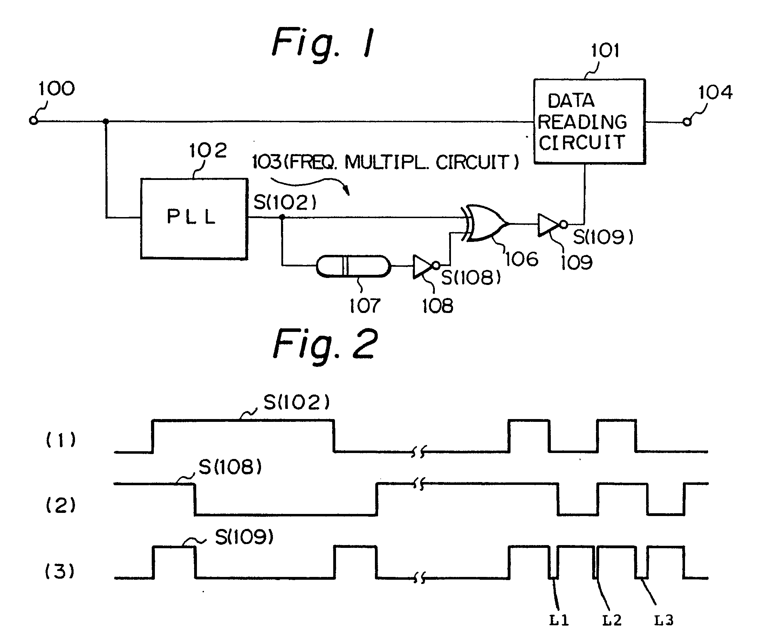

Before describing the preferred embodiments of the present invention, a prior art disc controller including a frequency multiplier circuit is described with reference to Figures 1 and 2. The prior art disc controller shown in Figure 1 includes an input terminal 100, a data reading circuit 101, a phase locked loop circuit 102, and a frequency multiplying circuit 103 having a delay circuit 107, an inverter 108, an exclusive OR gate 106, and an inverter 109.

The clock signal S(102) as the output of the phase locked loop circuit 102 is supplied to one input terminal of the exclusive OR gate 106 and the delay circuit 107. The output of the delay circuit 107 is supplied to the inverter 108 which produces the inverted signal S(108) to be supplied to the other input terminal of the exclusive OR gate 106. The output of the exclusive OR gate 106 is supplied to the inverter 109 which produces the inverted signal S(109) to be supplied to one input terminal of the data reading circuit 101.

The waveforms of the signals S(I02), S(I08), and S(I09) are shown in Fig. 2. The pulses S(I09) are produced at the rising edges and the falling edges of the clock pulses S(I02). Thus, the frequency of the pulses S(I09) is twice that of the pulses S(I02).

In practice, in the circuit shown in Fig. 1, the oscillation frequency in the phase locked loop circuit I2 is subject to considerable changes in a lock-in process with regard to a regenerative signal, so that the frequency of the clock signal S(I02) is subject to considerable changes.

As the frequency of the clock signal S(I02) increases, as shown in right part of the waveform (I) in Fig. 2, the lengths of the LOW level potential periods LI, L2, and L3 become quite short, as shown in the right part of the waveform (3) in Fig. 2, causing the frequency of the output signal S(I09) to be considerably high.

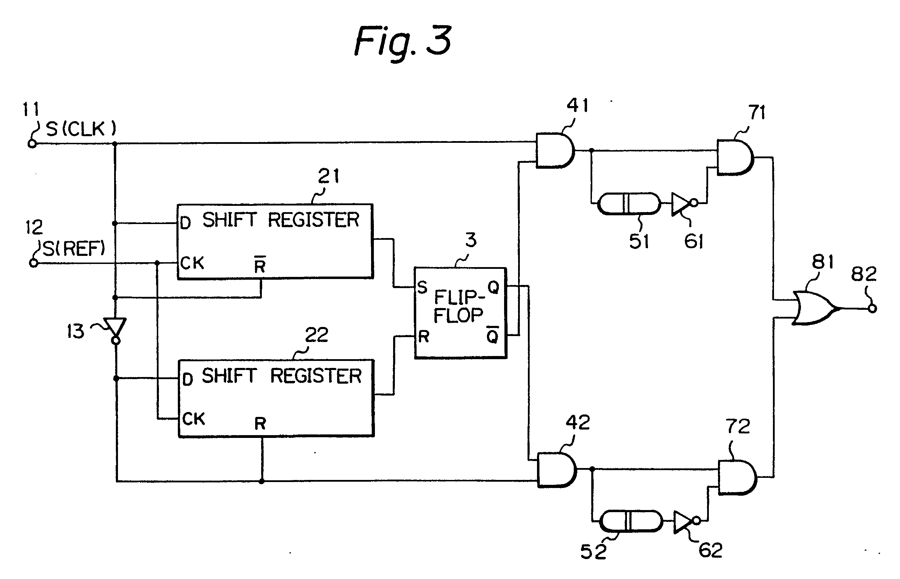

This high frequency of the output signal S(I09) will cause an abnormal operation of the data reading circuit I0I. The supply of the signals S(I09), shown in the right part of the waveform (3) in Fig. 3, having short intervals LI, L2, and L3, to the data reading circuit I0I will prevent the data reading circuit I0I from attaining a normal operation.

The arrangement of a frequency multiplying circuit according to a preferred embodiment of the present invention is shown in Fig. 3. The circuit of Fig. 3 includes a clock signal inputting terminal II, a reference signal inputting terminal I2, an inverter I3, a first shift register 2I as a first timing means, a second shift register 22 as a second timing means, an S-R flip-flop circuit 3 as a gating timing determination means, AND gates 4I and 42, delay circuits 5I and 52, inverters 6I and 62, AND gates 7I and 72, an OR gate 8I, and an output terminal 82.

Clock signals S(CLK) from a phase locked loop circuit are supplied through the input terminal II to the data terminal D and the reset terminal $\overline{R}$ - (inverted R) of the shift register 2I, the inverter I3, and one input terminal of the AND gate 4I. The output of the inverter I3, which is an inversion of the clock signals, is supplied to the data terminal D and the reset terminal $\overline{R}$ of the shift register 22, and the AND gate 42.

The clock signal S(CLK) has a frequency of, for example, 500 kHz.

A reference signal S(REF) having a predetermined constant frequency is supplied through the input terminal I2 to the clock input terminals CK of the shift registers 2I and 22. The reference signal S(REF) is not synchronized with the clock signal S-(CLK).

In each of the shift registers 2I and 22, the RESET state is cancelled when the potential of the reset terminal $\overline{R}$ becomes HIGH level. After the cancellation of the RESET state, each time the reference signal pulse S(REF) is supplied to the clock input terminal CK, the HIGH level clock signal S(CLK) (or the inverted clock signal $\overline{S(CLK)}$) is taken into the shift register, and the taken clock signal S(CLK) (or the taken inverted clock signal $\overline{S-(CLK)}$) is shifted in the shift register, and the delayed clock signal (or the delayed inverted clock signal) delayed by, for example, 4 cycle periods of the reference signal S(REF), is delivered from the output terminal of the shift register. When the potential of the reset terminal $\overline{R}$ becomes LOW level, the shift register is in the RESET state and the potential of the output terminal of the shift register becomes LOW level.

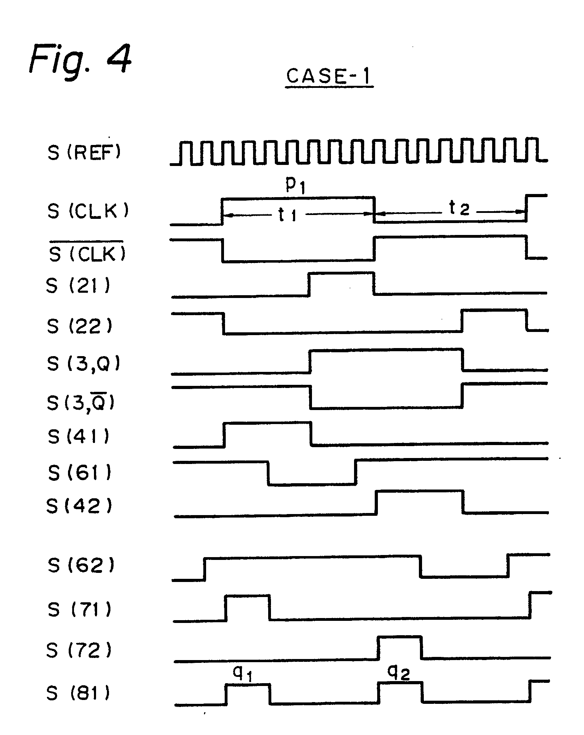

Examples of the waveforms of the signals appearing in the circuit of Fig. 3 are shown in Figs. 4, 5, 6, and 7. For example, the reference signal S-(REF), the input clock signal S(CLK), the inverted input clock signal $\overline{S(CLK)}$, the output S(2I) of the shift register 2I, the output S(22) of the shift register 22, the Q output S(3, Q) of the flip-flop circuit 3, the $\overline{Q}$ output S(3, $\overline{Q}$) of the flip-flop circuit 3, the output S(4I) of the AND gate 4I, the output S(6I) of the inverter 6I, the output S(42) of the AND gate 42, the output S(62) of the inverter 62, the output S(7I) of the AND gate 7I, the output S(72) of the AND gate 72, and the output S(8I) of the OR gate 8I are shown in Fig. 4.

The shift register 2I delivers a HIGH level set signal S(2I) when the HIGH level period of the input clock signal S(CLK) exceeds 4 cycle periods of the reference signal S(REF), and the delivered signal S(2I) is supplied to the set terminal S of the SR flip-flop circuit 3.

The shift register 22 delivers a HIGH level reset signal S(22) when the LOW level period of the input clock signal S(CLK) exceeds 4 cycle periods of the reference signal S(REF), and the delivered signal S(22) is supplied to the reset terminal R of the SR flip-flop circuit 3.

The internal state of the flip-flop circuit 3 is reversed by a set signal and a reset signal incoming through the set terminal S and the reset terminal R, so that the signal S(3, Q) from the Q terminal is supplied to one input terminal of the AND gate 42 and the signal S(3, $\overline{Q}$) from the $\overline{Q}$ terminal is supplied to one input terminal of the AND gate 4I.

The AND gate 4I passes the clock signal S-(CLK) during the period in which the potential of the signal S(3, $\overline{Q}$) is HIGH level. The output clock signal of the AND gate 4I is supplied to one input terminal of the AND gate 7I and the delay circuit 5I. The output S(5I) of the delay circuit 5I, which is delayed by a predetermined time of, for example, 2 cycle periods of the reference signal S(REF), from the input S(4I) of the delay circuit 5I is inverted by the inverter 6I. The output S(6I) of the inverter 6I is

supplied to the other input terminal of the AND gate 7I.

Accordingly, after the LOW level period of the input clock signal S(CLK) exceeds 4 cycle periods of the reference signal S(REF) and the potential of the $\overline{Q}$ output S(3, $\overline{Q}$) of the flip-flop circuit 3 becomes HIGH level, when the potential of the clock signal S(CLK) rises, the AND gate 7I produces a first pulse S(7I) having a length of, for example, 2 cycle periods of the reference signal S(REF). The produced first pulse S(7I) is supplied to the OR gate 8I.

The AND gate 42 passes the inverted clock signal $\overline{S(CLK)}$ during the period in which the potential of the signal S(3, Q) is HIGH level. The output inverted clock signal of the AND gate 42 is supplied to one input terminal of the AND gate 72 and the delay circuit 52. The output S(52) of the delay circuit 52, which is delayed by a predetermined time of, for example, 2 cycle periods of the reference signal S(REF), from the input S(42) of the delay circuit 52 is inverted by the inverter 62. The output S(62) of the inverter 62 is supplied to the other input terminal of the AND gate 72.

Accordingly, after the HIGH level period of the input clock signal S(CLK) exceeds 4 cycle periods of the reference signal S(REF) and the potential of the Q output S(3, Q) of the flip-flop circuit 3 becomes HIGH level, when the potential of the clock signal S(CLK) falls, the AND gate 72 produces a second pulse S(72) having a length of, for example, 2 cycle periods of the reference signal S(REF). The produced second pulse S(72) is supplied to the OR gate 8I.

The OR gate 8I to which the first and second pulses S(7I) and S(72) are supplied produces a pulse signal S(8I) which is delivered from the output terminal 82.

In accordance with the sequence of the levels of the potential of the input clock signal S(CLK), the following four examples of the operation of the frequency multiplying circuit of Fig. 3 are considered.

(Case-I) Each of the HIGH level period and the LOW level period of the potential of the input clock signal S(CLK) exceeds 4 cycle periods of the S(REF). The waveforms of the signals in Case-I are shown in Fig. 4.

In the case of Fig. 4, each of the HIGH level potential period tI and the LOW level potential period t2 of the S(CLK) exceeds 4 cycle periods of the S(REF). The setting and the resetting of the flip-flop circuit 3 are carried out at 4 cycle period of the S(REF) after the rising and the falling of the S(CLK), as shown in S(2I) and S(22). The Q and $\overline{Q}$ outputs of the flip-flop circuit 3 are as shown in S(3, Q) and S(3, $\overline{Q}$). The outputs of the AND gates 4I and 42 are as shown in S(4I) and S(42). The outputs of the delay circuits 5I and 52, which are delayed by 2 cycle periods of S(REF) from the inputs, are as shown in S(6I) and S(62). The outputs of the AND gates 7I and 72 are as shown in S(7I) and S(72). Thus, the output signal qI, q2, ... of the OR gate 8I is as shown in S(8I).

Accordingly, in the case of Fig. 4, the frequency of the output signal S(8I) is twice that of the input clock signal S(CLK).

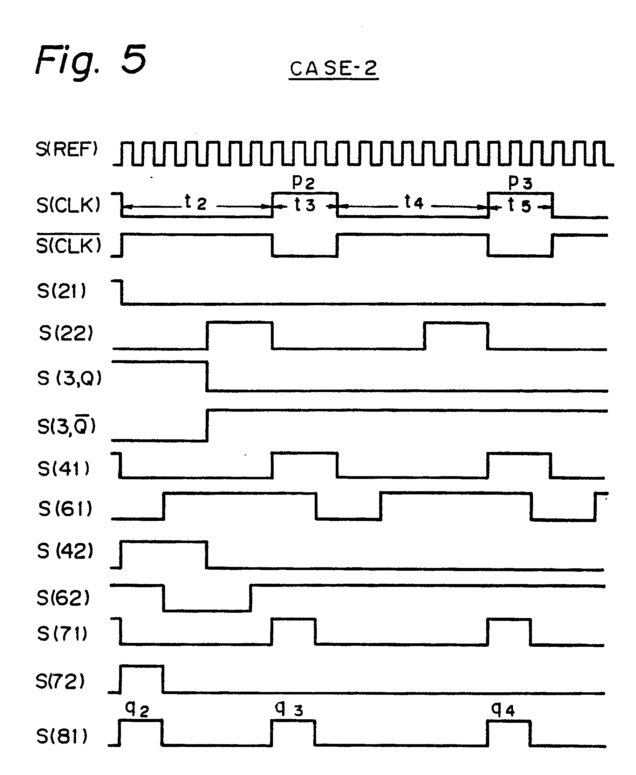

(Case-2) The length of the preceding LOW level period of the potential of the input clock signal S(CLK) exceeds 4 cycle periods of the S(REF), and the length of the present HIGH level period of the potential of the input clock signal S(CLK) is less than 4 cycle periods of the S(REF). The waveforms of the signals in Case-2 are shown in Fig. 5.

In the case of Fig. 5, the preceding LOW level periods t2, t4 exceed 4 cycle periods of the S(REF), and the present HIGH level periods t3, t5 are less than 4 cycle periods of the S(REF).

The input clock signal S(CLK) is not delivered from the shift register 2I. After 4 cycle periods of the S(REF) from the falling of the S(CLK), the reversal of the outputs of the flip-flop circuit 3 does not take place, so that the potential of the $\overline{Q}$ output S(3, $\overline{Q}$) of the flip-flop circuit 3 is maintained at a HIGH level.

The outputs of the AND gate 4I, the inverter 6I, the AND gate 42, the inverter 62, the AND gate 7I, and the inverter 72 are as shown in S(4I), S(6I), S(42), S(62), S(7I), and S(72). The AND gate 7I delivers the output pulses at the risings of the input clock pulses S(CLK), but the AND gate 72 does not deliver the output pulses. Therefore, the OR gate 8I delivers only the signals q3, q4, ... as shown in S(8I).

Accordingly, the frequency of the output signal is not multiplied from the frequency of the input clock signal but is maintained at the same levels as the frequency of the input clock signal.

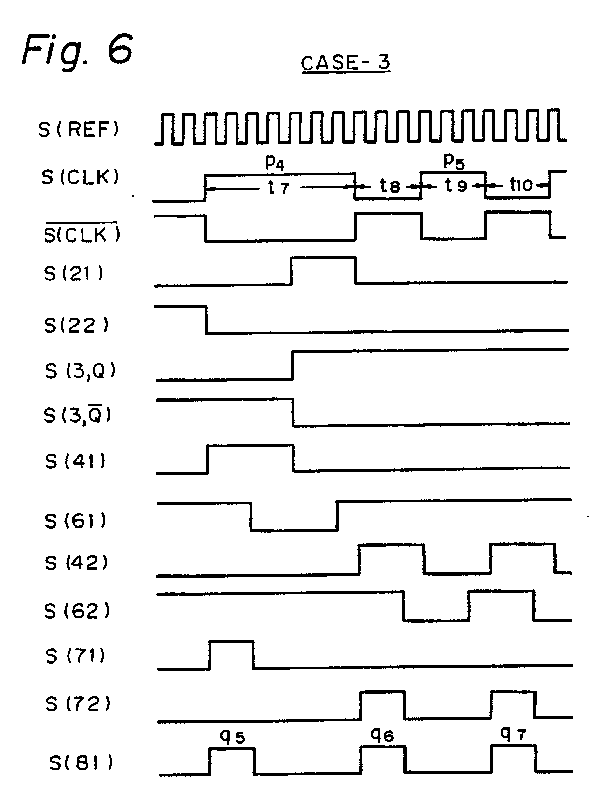

(Case-3) The length of the preceding HIGH level period of the potential of the input clock signal S(CLK) exceeds 4 cycle periods of the S(REF), and the length of the present LOW level period of the potential of the input clock signal S(CLK) is less than 4 cycle periods of the S(REF). The waveforms of the signals in Case-3 are shown in Fig. 6.

In the case of Fig. 6, the preceding HIGH level period t7 exceeds 4 cycle periods of the S(REF), and the present LOW level period t8 is less than 4 cycle periods of the S(REF).

The outputs of the shift registers 2I and 22 are as shown in S(2I) and S(22). At the time of the pulse p5, the reversal of the outputs of the flip-flop circuit 3 does not take place, so that the potential of the Q output S(3, Q) is maintained at a HIGH level, and the potential of the $\overline{Q}$ output S(3, $\overline{Q}$) is maintained at a LOW level.

The outputs of the AND gate 4l, the inverter 6l, the AND gate 42, the inverter 62, the AND gate 7l, and the inverter 72 are as shown in S(4l), S(6l), S-(42), S(62), S(7l), and S(72). The outputs q5, q6, q7, ... of the OR gate 8l are as shown in S(8l).

The pulses q5 and q6 are produced immediately after the rising and the falling of the input clock signal p4, and the pulse q7 is produced immediately after the falling of the input clock signal p5.

Accordingly, after the input of the clock signal p5, the frequency of the output signal is not multiplied by the frequency of the input clock signal but is maintained at the same level as the frequency of the input clock signal.

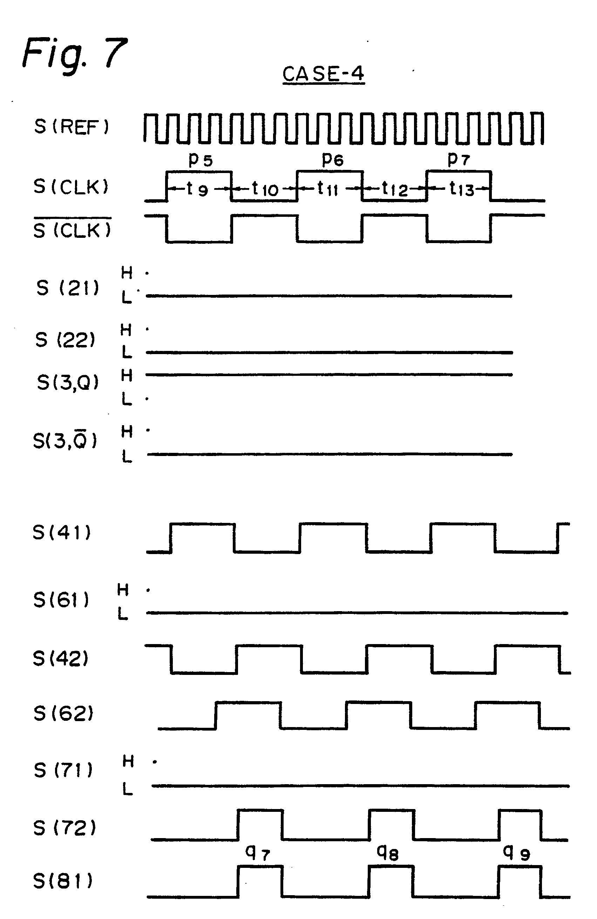

(Case-4) Each of the HIGH level period and the LOW level period of the potential of the input clock signal S(CLK) is less than 4 cycle periods of the S-(REF). The waveforms of the signals in Case-4 are shown in Fig. 7.

In the case of Fig. 7, each of the HIGH level periods t9, tll, tl3, ... and the LOW level periods tl0, tl2, ... is less than 4 cycle periods of the S(REF).

In the case of Fig. 7, each of the potentials of the outputs of the shift registers 2l and 22 is maintained at a LOW level. The Q output S(3, Q) of the flip-flop circuit 3 is maintained at a HIGH level, and the $\overline{Q}$ output S(3, $\overline{Q}$) of the flip-flip circuit 3 is maintained at a LOW level.

The outputs of the AND gate 4l, the inverter 6l, the AND gate 42, the inverter 62, the AND gate 7l, and the inverter 72 are as shown in S(4l), S(6l), S-(42), S(62), S(7l) and S(72). The outputs q7, q8, q9, ... of the OR gate 8l are as shown in S(8l). The pulses q7, q8, q9, ... are produced only immediately after the falling of the input clock signals p5, p6, p7, ...

Accordingly, the frequency of the output signal is not multiplied by the frequency of the input clock signal but is maintained at the same level as the frequency of the input clock signal.

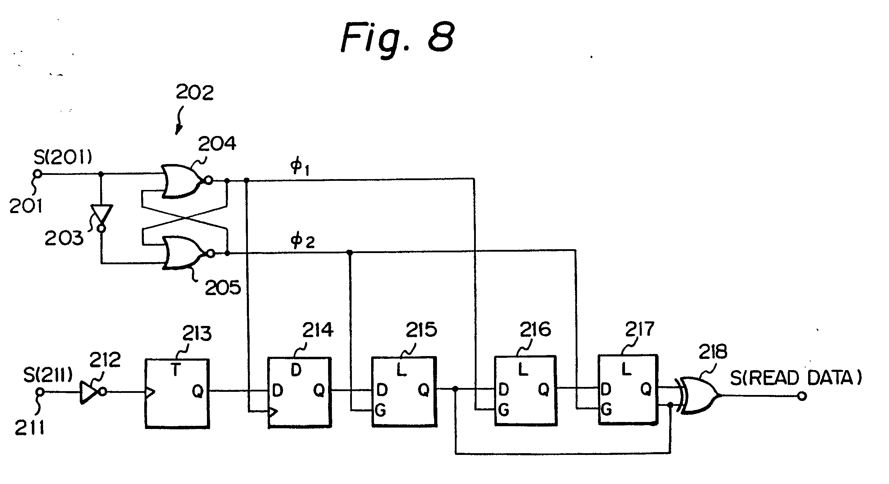

The output signal S(8l) of the frequency multiplying circuit of Fig. 3 is used for an input clock signal S(20l) of a data latch circuit shown in Fig. 8 as a data reading circuit. The data latch circuit shown in Fig. 8 includes a circuit 202 for generating double cycle period clock signals $\emptyset_1$ and $\emptyset_2$, a toggle flip-flop circuit 2l3, a D type flip-flop circuit 2l4, a sequence of three latch elements 2l5, 2l6, and 2l7, and an exclusive OR gate 2l8. The latch circuit shown in Fig. l delivers an output signal S-(READ DATA) from the exclusive OR gate 2l8.

In the data latch circuit shown in Fig. 8, the double cycle period clock signals $\emptyset_1$ and $\emptyset_2$ delivered from the circuit 202 are supplied to one input terminal of the D type flip-flip circuit 2l4 and the Latch elements 2l5, 2l6, and 2l7.

## Claims

1. A frequency multiplying circuit comprising:

a reference input frequency (S(REF));

a first time counting means (21) responsive to input pulse signals for producing a first detection signal when said input pulse signals maintain a HIGH level for a time greater than that required for a predetermined number of periods of the reference input;

a second time counting means (22) responsive to the input pulse signals for producing a second detection signal when said input pulse signals maintain a LOW level for a time greater than that required for a predetermined number of periods of the reference input;

a pulse generation determining means (3) responsive to said produced first and second detection signals for realizing a SET state by said produced first detection signal and realizing a RESET state by said produced second detection signal to generate gate signals;

a first pulse generating means (41,51,61,71) responsive to one of said generated gate signals for detecting rising edges of said input pulse signals to generate first pulses which are substantially synchronous with said rising edges;

a second pulse generating means (42,52,62,72) responsive to the other of said generated gate signals for detecting falling edges of said input pulse signals to generate second pulses which are substantially synchronous with said falling edges;

said first and second pulses being delivered as frequency multiplied signals of said input pulse signals;

whereby the frequency multiplication of said input pulse signals only occurs when the period of said input pulse signals exceeds the time required for a predetermined number of periods of the reference input.

2. A frequency multiplying circuit according to claim 1, wherein said first pulse generating means comprises:

a first delay circuit (51) for delaying by a predetermined period a detected signal which is detected according to one of said generated gate signals and the rising edge of a said input pulse signal, and

a first output circuit (71) for outputting said first pulse by combining said detected signal and said delayed signal.

3. A frequency multiplying circuit according to claim 1, wherein said second pulse generating means comprises:

a second delay circuit (52) for delaying by a predetermined period a detected signal which is detected according to the other of said generated gate signals and the falling edge of a said input pulse signal, and

a second output circuit (72) for outputting said second pulse by combining said detected signal and said delayed signal.

**Revendications**

1. Circuit multiplieur de fréquence comprenant :

une fréquence d'entrée de référence (S-(REF)) ;

un premier moyen de comptage du temps (21) sensible à des signaux d'impulsion d'entrée pour produire un premier signal de détection lorsque lesdits signaux d'impulsion d'entrée maintiennent un niveau HAUT pendant une durée supérieure à la durée nécessaire pour un nombre prédéterminé de périodes de l'entrée de référence ;

un second moyen de comptage du temps (22) qui est sensible aux signaux d'impulsion d'entrée pour produire un second signal de détection lorsque lesdits signaux d'impulsion d'entrée maintiennent un niveau BAS pendant une durée supérieure à la durée nécessaire pour un nombre prédéterminé de périodes de l'entrée de référence ;

un moyen de détermination de génération d'impulsion (3) sensible auxdits premier et second signaux de détection produits, pour établir un état de mise en fonctionnement au moyen dudit premier signal de détection produit et pour établir un état de remise à l'état initial au moyen dudit second signal de détection produit afin de générer des signaux de portes ;

un premier moyen de génération d'impulsion (41, 51, 61, 71) sensible à un desdits signaux de portes générés pour détecter des fronts montants desdits signaux d'impulsion d'entrée afin de générer des premières impulsions qui sont sensiblement synchrones avec lesdits fronts montants ;

un second moyen de générations d'impulsion (42, 52, 62, 72) sensible à l'autre desdits signaux de portes générés pour détecter des fronts descendants desdits signaux d'impulsion d'entrée afin de générer des secondes impulsions qui sont sensiblement synchrones avec lesdits fronts descendants ;

lesdites première et seconde impulsions étant délivrées en tant que signaux multipliés en fréquence par lesdits signaux d'impulsion d'entrée ;

d'où il résulte que la multiplication en fréquence desdits signaux d'impulsion d'entrée se produit seulement lorsque la période desdits signaux d'impulsion d'entrée excède la durée nécessaire pour un nombre prédéterminé de périodes de l'entrée de référence.

2. Circuit multiplieur de fréquence selon la revendication 1, dans lequel ledit premier moyen de génération d'impulsion comprend :

un premier circuit de retard (51) pour retarder d'une période prédéterminée un signal détecté, celui-ci étant détecté en fonction d'un desdits signaux de portes générés et du front montant d'un dit signal d'impulsion d'entrée ; et

un premier circuit de sortie (71) pour émettre en sortie ladite première impulsion en combinant ledit signal détecté et ledit signal retardé.

3. Circuit multiplieur de fréquence selon la revendication 1, dans lequel ledit second moyens de génération d'impulsion comprend :

un second circuit de retard (52) pour retarder d'une période prédéterminée un signal détecté, celui-ci étant détecté en fonction de l'autre desdits signaux de portes générés et du front descendant d'un dit signal d'impulsion d'entrée ; et

un second circuit de sortie (72) pour émettre en sortie ladite seconde impulsion en combinant ledit signal détecté et ledit signal retardé.

**Patentansprüche**

1. Eine Frequenz-Multiplizierschaltung mit:

einer Referenz-Eingabefrequenz (S(REF));

einer ersten Zeitzählungseinrichtung (21), die auf Eingabeimpulssignale anspricht, zur Erzeugung eines ersten Erkennungssignals, wenn die Eingabeimpulssignale über einen größeren Zeitabschnitt als den, der für eine vorbestimmte Anzahl von Perioden der Referenzeingabe erforderlich ist, einen hohen Pegel (HIGH) aufrechterhalten;

einer zweiten Zeitzähleinrichtung (22), die auf Eingabeimpulssignale anspricht, zur Erzeugung eines zweiten Erkennungssignals, wenn die Eingabeimpulssignale über einen größeren Zeitabschnitt als den, der für eine vorbestimmte Anzahl von Perioden der Referenzeingabe erforderlich ist, einen niedrigen Pegel (LOW) aufrechterhalten;

einer Impulserzeugungs-Bestimmungseinrichtung (3), die auf die erzeugten ersten und zweiten Erkennungssignale anspricht, zur Durchführung eines Setz-Status durch das erzeugte erste Erkennungssignal und zur Durchführung eines Rücksetz-Status durch das erzeugte zweite Erkennungssignal, um Torsignale zu erzeugen;

einer ersten Impulserzeugungseinrichtung (41,51,61,71), die auf eines der erzeugten Torsignale anspricht, zur Erkennung von ansteigenden Flanken der Eingabeimpulssignale, um erste Impulse zu erzeugen, die mit den ansteigenden Flanken im wesentlichen synchron sind;

einer zweiten Impulserzeugungseinrichtung (42,52,62,72), die auf die anderen erzeugten Torsignale anspricht, zur Erkennung von fallenden Flanken der Eingabeimpulssignale zur Erzeugung von zweiten Impulsen, die im wesentlichen mit den fallenden Flanken synchron sind;

wobei die ersten und zweiten Impulse als frequenz-multiplizierte Signale der Eingabeimpulssignale abgegeben werden;

wodurch die Frequenz-Multiplikation der Eingabeimpulssignale nur eintritt, wenn die Periode der Eingabeimpulssignale über den Zeitabschnitt hinaus geht, der für eine vorbestimmte Zahl von Perioden der Referenzeingabe erforderlich ist.

2. Eine Frequenz-Multiplizierschaltung gemäß Anspruch 1, worin die erste Impulserzeugungseinrichtung enthält:

eine erste Verzögerungsschaltung (51) zur Verzögerung, um eine vorbestimmte Periode, eines erkannten Signals, welches entsprechend einem der erzeugten Torsignale und der ansteigenden Flanke eines der genannten Eingabeimpulssignale erkannt wurde und

eine erste Ausgabeschaltung (71) zur Ausgabe des ersten Impulses durch Kombination des erkannten Signals mit dem verzögerten Signal.

3. Eine Frequenz-Multiplizierschaltung gemäß Anspruch 1, worin die zweite Impulserzeugungseinrichtung enthält:

eine zweite Verzögerungsschaltung (52) zur Verzögerung, um eine vorbestimmte Periode, eines erkannten Signals, welches entsprechend dem anderen der erzeugten Torsignale und der fallenden Flanke eines der genannten Eingabeimpulssignale erkannt wurde, und

eine zweite Ausgabeschaltung (72) zur Ausgabe des zweiten Impulses durch Kombination des erkannten Signals mit dem verzögerten Signal.

# Fig. I

# Fig. 2

EP 0 243 075 B1

# Fig. 3

EP 0 243 075 B1

# Fig. 4

## CASE-1

| Signal | Waveform |
|---|---|
| S (REF) | |
| S (CLK) | $p_1$, $t_1$, $t_2$ |
| $\overline{S (CLK)}$ | |
| S (21) | |
| S (22) | |
| S (3,Q) | |
| S (3,$\overline{Q}$) | |
| S (41) | |
| S (61) | |
| S (42) | |
| S (62) | |
| S (71) | |
| S (72) | |
| S (81) | $q_1$, $q_2$ |

# Fig. 5

CASE-2

## Fig. 6

CASE- 3

S(REF)

S(CLK)

$\overline{S(CLK)}$

S(21)

S(22)

S(3,Q)

S(3,$\overline{Q}$)

S(41)

S(61)

S(42)

S(62)

S(71)

S(72)

S(81)

# Fig. 7

### CASE-4

Timing diagram showing waveforms:
- S(REF)
- S(CLK) with p5, p6, p7 and t9, t10, t11, t12, t13
- $\overline{S(CLK)}$
- S(21) H/L
- S(22) H/L
- S(3,Q) H/L
- S(3,$\overline{Q}$) H/L
- S(41)
- S(61) H/L
- S(42)
- S(62)
- S(71) H/L
- S(72)
- S(81) with q7, q8, q9

13

Fig. 8

EP 0 243 075 B1